# EUROPEAN PATENT APPLICATION

(11) **EP 4 653 897 A1**
(43) Date of publication of application: **26.11.2025**
(21) Application number: 23924337.1
(22) Date of filing: 17.11.2023
(51) Int. Cl.: G01R 31/396, G01R 31/392, G01R 31/382, G01R 31/385, G01R 19/165, G01R 19/10, G01R 19/30, G01R 19/00, B60L 58/12, B60L 58/16

(54) **BATTERY DIAGNOSTIC DEVICE AND OPERATION METHOD THEREOF**

(30) Priority: 21.02.2023 KR 20230023231; 26.05.2023 KR 20230068251
(71) Applicant: LG Energy Solution, Ltd., Seoul 07335 (KR)
(72) Inventor: KIM, Young Min, Daejeon 34122 (KR); PARK, Jung Uk, Daejeon 34122 (KR); IN, Jeong Hyeon, Daejeon 34122 (KR)
(74) Representative: Plasseraud IP
(86) International application number: PCT/KR2023/018592
(87) International publication number: WO 2024/177231

(57) **Abstract**

A battery diagnosis apparatus according to an embodiment disclosed herein includes an obtaining unit configured to obtain open circuit voltage (OCV) data of a battery cell, a calculating unit configured to calculate an OCV change value of each of a plurality of battery cells included in a specific battery module, in a designated time window, based on the OCV data, and calculate an average-to-OCV deviation value indicating a difference value between an average OCV change value of the plurality of battery cells and an OCV change value of a specific battery cell among the plurality of battery cells, and a diagnosing unit configured to diagnose abnormality of the specific battery cell, based on the average-to-OCV deviation value of the specific battery cell.

## Description

### [Technical Field]

### CROSS-REFERENCE TO RELATED APPLICATION

This application claims priority to and the benefit of Korean Patent Application No. 10-2023-0023231 filed in the Korean Intellectual Property Office on February 21, 2023, and Korean Patent Application No. 10-2023-0068251 filed in the Korean Intellectual Property Office on May 26, 2023, the entire contents of which are incorporated herein by reference.

### TECHNICAL FIELD

Embodiments disclosed herein relate to a battery diagnosis apparatus and an operating method thereof.

### [Background Art]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may also be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

### [Disclosure]

### [Technical Problem]

When a short circuit or a failure of another type occurs inside a battery, the possibility of damage to devices (e.g., EV, ESS) including the battery may increase. Accordingly, there is a need for a scheme to reduce the possibility of damage to devices including a battery by detecting an abnormal state of the battery.

Conventionally, a battery cell has been diagnosed by a calculation scheme using all of a state of charge (SOC), current, capacity, and open circuit voltage (OCV) information. According to such a diagnosis method, because of use of many factors, it may be difficult to perform diagnosis when specific information out of the foregoing information is missing. This may be a big issue in the battery management system implemented with a server device that has to collect data from the vehicle, and may excessively increase memory usage. Thus, there is a need for data simplification required for battery diagnosis.

According to embodiments disclosed herein, there may be provided a battery diagnosis apparatus and an operating method thereof by which abnormality of a battery may be diagnosed merely using battery OCV data information.

Technical problems of the embodiments disclosed herein are not limited to the above-described technical problems, and other unmentioned technical problems would be clearly understood by one of ordinary skill in the art from the following description.

### [Technical Solution]

A battery diagnosis apparatus according to an embodiment disclosed herein includes an obtaining unit configured to obtain open circuit voltage (OCV) data of a battery cell, a calculating unit configured to calculate an OCV change value of each of a plurality of battery cells included in a specific battery module, in a designated time window, based on the OCV data, and calculate an average-to-OCV deviation value indicating a difference value between an average OCV change value of the plurality of battery cells and an OCV change value of a specific battery cell among the plurality of battery cells, and a diagnosing unit configured to diagnose abnormality of the specific battery cell, based on the average-to-OCV deviation value of the specific battery cell.

In the battery diagnosis apparatus according to an embodiment, the designated time window may be set to a time window between a first point in time before execution of charging and a second point in time after execution of the charging of the battery cell.

In the battery diagnosis apparatus according to an embodiment, the diagnosing unit may be further configured to increase a diagnosis count of the specific battery cell when the average-to-OCV deviation value of the specific battery cell satisfies a first designated range, reduce the diagnosis count of the specific battery cell when the average-to-OCV deviation value of the specific battery cell satisfies a second designated range that is different from the first designated range, and diagnose the specific battery cell as an abnormal battery cell when the diagnosis count of the specific battery cell reaches a threshold count.

In the battery diagnosis apparatus according to an embodiment, the calculating unit may be further configured to calculate a maximum-average OCV deviation value indicating a difference value between a maximum OCV change value of the plurality of battery cells and the average OCV change value of the plurality of battery cells, and the diagnosing unit may be further configured to diagnose abnormality of the specific battery module, based on the maximum-average OCV deviation value.

In the battery diagnosis apparatus according to an embodiment, the calculating unit may be further configured to calculate a plurality of OCV change values of each of the plurality of battery cells, in a plurality of time windows, based on the OCV data, calculate a plurality of reference values one-to-one corresponding respectively to each of the plurality of battery cells and indicating an average value of at least some of the plurality of OCV change values of each of the plurality of battery cells in the plurality of time windows, and calculate a maximum reference value indicating a maximum value among the plurality of reference values, and the diagnosing unit may be further configured to diagnose abnormality of the specific battery module, based on the maximum reference value of the specific battery module.

In the battery diagnosis apparatus according to an embodiment, the calculating unit may be further configured to calculate a plurality of maximum reference values one-to-one corresponding respectively to each of a plurality of battery modules included in a battery pack, and the diagnosing unit may be further configured to diagnose abnormality of the battery pack, based on a maximum value among the plurality of maximum reference values of the plurality of battery modules.

In the battery diagnosis apparatus according to an embodiment, the calculating unit may be further configured to extract OCV data in a designated voltage range from the OCV data and calculate the OCV change value of each of the plurality of battery cells, based on the extracted OCV data in the designated voltage range.

A battery diagnosis method according to an embodiment disclosed herein includes obtaining open circuit voltage (OCV) data of a battery cell, calculating an OCV change value of each of a plurality of battery cells included in a specific battery module, in a designated time window, based on the OCV data, calculating an average-to-OCV deviation value indicating a difference value between an average OCV change value of the plurality of battery cells and an OCV change value of a specific battery cell among the plurality of battery cells, and diagnosing abnormality of the specific battery cell, based on the average-to-OCV deviation value of the specific battery cell.

In the battery diagnosis method according to an embodiment disclosed herein, the designated time window may be set to a time window between a first point in time before execution of charging and a second point in time after execution of the charging of the battery cell.

In the battery diagnosis apparatus according to an embodiment disclosed herein, the diagnosing of the abnormality of the specific battery cell may include increasing a diagnosis count of the specific battery cell when the average-to-OCV deviation value of the specific battery cell satisfies a first designated range, reducing the diagnosis count of the specific battery cell when the average-to-OCV deviation value of the specific battery cell satisfies a second designated range that is different from the first designated range, and diagnosing the specific battery cell as an abnormal battery cell when the diagnosis count of the specific battery cell reaches a threshold count.

The battery diagnosis method according to an embodiment disclosed herein may further include calculating a maximum-average OCV deviation value indicating a difference value between a maximum OCV change value of the plurality of battery cells and the average OCV change value of the plurality of battery cells and diagnosing abnormality of the specific battery module, based on the maximum-average OCV deviation value.

The battery diagnosis method according to an embodiment disclosed herein may further include calculating a plurality of OCV change values of each of the plurality of battery cells, in a plurality of time windows, based on the OCV data, calculating a plurality of reference values one-to-one corresponding respectively to each of the plurality of battery cells and indicating an average value of at least some of the plurality of OCV change values of each of the plurality of battery cells in the plurality of time windows, calculating a maximum reference value indicating a maximum value among the plurality of reference values, and diagnosing abnormality of the specific battery module, based on the maximum reference value of the specific battery module.

The battery diagnosis method according to an embodiment disclosed herein may further include calculating a plurality of maximum reference values one-to-one corresponding respectively to each of a plurality of battery modules included in a battery pack and diagnosing abnormality of the battery pack, based on a maximum value among the plurality of maximum reference values of the plurality of battery modules.

In the battery diagnosis method according to an embodiment disclosed herein, the calculating of the OCV change value of each of the plurality of battery cells may include extracting OCV data in a designated voltage range from the OCV data and calculating the OCV change value of each of the plurality of battery cells, based on the extracted OCV data in the designated voltage range.

### [Advantageous Effects]

According to embodiments disclosed herein, data used for abnormality diagnosis of a battery may be simplified.

Moreover, various effects recognized directly or indirectly from the disclosure may be provided.

### [Description of Drawings]

FIG. 1 is a block diagram of a battery diagnosis apparatus according to an embodiment.
FIG. 2 is a view for describing an example in which a battery diagnosis apparatus diagnoses abnormality of a battery cell.
FIG. 3 is a view for describing an example in which a battery diagnosis apparatus diagnoses abnormality of a battery module.
FIG. 4 is a view for describing an example in which a battery diagnosis apparatus diagnoses abnormality of a battery module.
FIG. 5 is a view for describing an example in which a battery diagnosis apparatus diagnoses abnormality of a battery pack.
FIG. 6 is an operating flowchart of a battery diagnosis apparatus according to an embodiment.
FIG. 7 is an operating flowchart of a battery diagnosis apparatus according to an embodiment.
FIG. 8 is an operating flowchart of a battery diagnosis apparatus according to an embodiment.
FIG. 9 is an operating flowchart of a battery diagnosis apparatus according to an embodiment.
FIG. 10 is an operating flowchart of a battery diagnosis apparatus according to an embodiment.

### [Mode for Invention]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

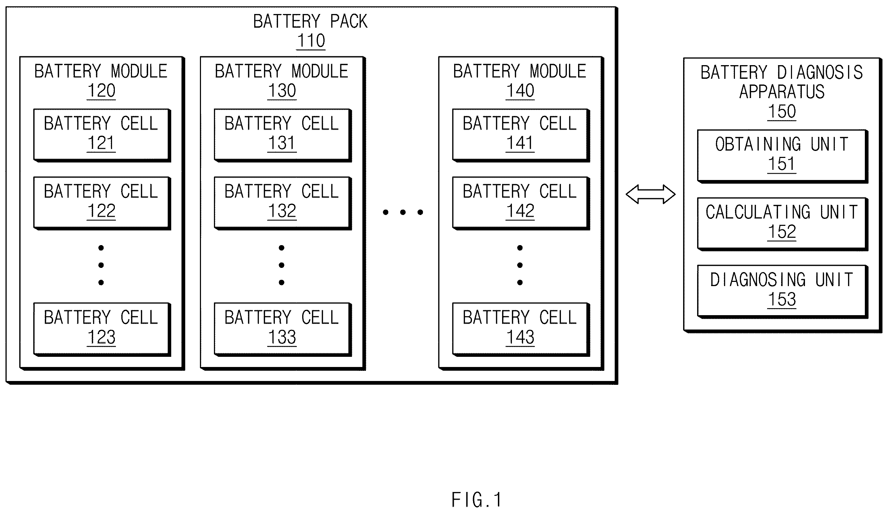

FIG. 1 is a block diagram of a battery diagnosis apparatus according to an embodiment.

Referring to FIG. 1, a battery pack 110 may include a plurality of battery modules 120, 130 and 140 which respectively include a plurality of battery cells 121, 122, 123, 131, 132, 133, 141, 142, and 143. According to an embodiment, the battery pack 110 may be a battery mounted inside an electric vehicle to supply power to the electric vehicle.

According to an embodiment, a battery diagnosis apparatus 150 may diagnose abnormality of a battery unit based on open circuit voltage (OCV) data obtained from the battery unit. In the present disclosure, the battery unit may mean the battery pack 110, the battery module 120, 130, or 140, or the battery cell 121, 122, 123, 131, 132, 133, 141, 142, or 143.

According to an embodiment, the battery diagnosis apparatus 150 may be formed integrally with the battery unit. In this case, the battery diagnosis apparatus 150 may be included in a battery management system (BMS) of the battery unit.

According to an embodiment, the battery diagnosis apparatus 150 may be formed separately from the battery unit. In this case, the battery diagnosis apparatus 150 may be implemented with an external server connected to the battery unit over a wireless network.

According to an embodiment, the battery diagnosis apparatus 150 may include an obtaining unit 151, a calculating unit 152, and a diagnosing unit 153.

According to an embodiment, the obtaining unit 151 may obtain OCV data of the battery cells 121, 122, 123, 131, 132, 133, 141, 142, and/or 143. For example, the obtaining unit 151 may measure voltages, currents, and/or temperatures of the battery cells 121, 122, 123, 131, 132, 133, 141, 142, and/or 143 and configure OCV data based on the measured information. In this case, the obtaining unit 151 may include a sensor for measuring the voltages, currents, and/or temperatures of the battery cells 121, 122, 123, 131, 132, 133, 141, 142, and/or 143 and a processor for configuring OCV data based on the measured information. In another example, the obtaining unit 151 may receive OCV data of the battery cells 121, 122, 123, 131, 132, 133, 141, 142, and/or 143, obtained by the battery unit. In this case, the obtaining unit 151 may include a communication circuit capable of performing wired and/or wireless network communication.

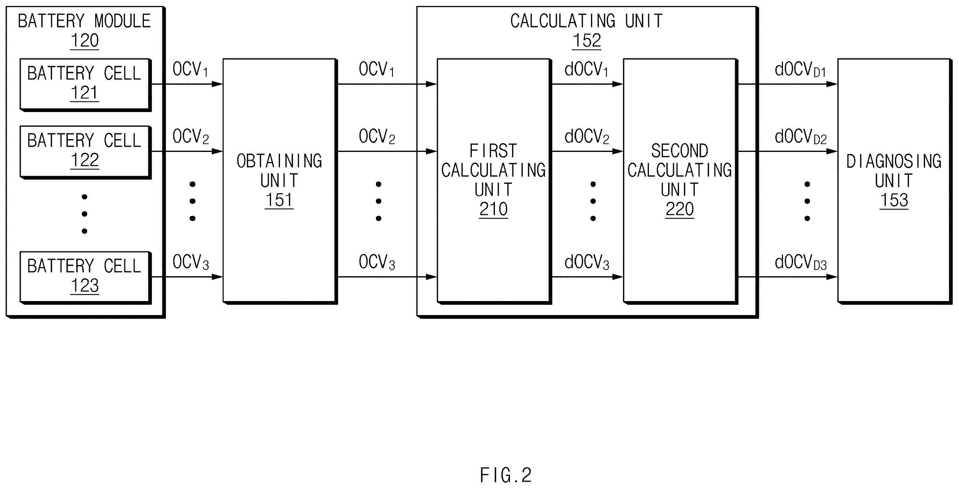

According to an embodiment, the calculating unit 152 may calculate a determination value (e.g., an OCV change value, an average-to-OCV deviation value, a maximum-average OCV deviation value, a reference value, and/or a maximum reference value) based on the OCV data obtained by the obtaining unit 151. According to an embodiment, the calculating unit 152 may extract OCV data in a designated voltage range from the OCV data. The calculating unit 152 may calculate the determination value based on the extracted OCV data in the designated voltage range. Various embodiments for calculating the determination value by the calculating unit 152 will be described in detail with reference to FIGS. 2 to 5 below.

According to an embodiment, the diagnosing unit 153 may diagnose abnormality of the battery unit based on the determination value calculated by the calculating unit 152.

According to an embodiment, the diagnosing unit 153 may compare the determination value with a threshold value corresponding thereto to diagnose abnormality of the battery unit. For example, the diagnosing unit 153 may diagnose the battery unit (e.g., the battery module 120, 130, or 140) as an abnormal battery unit when the determination value (e.g., a maximum-average OCV deviation value) is greater than or equal to a threshold value (e.g., 0.015 mV).

According to an embodiment, the diagnosing unit 153 may increase or reduce a diagnosis count based on a range in which the determination value falls and compare a diagnosis count with a threshold count to diagnose abnormality of the battery unit. According to an embodiment, the diagnosing unit 153 may increase the diagnosis count of the battery unit when the determination value satisfies a first designated range. The diagnosing unit 153 may reduce the diagnosis count of the battery unit when the determination value satisfies a second designated range different from the first designated range. The diagnosing unit 153 may diagnose the battery unit as an abnormal battery unit when the diagnosis count reaches the threshold count.

The calculating unit 152 and the diagnosing unit 153 may be implemented as a single processor or separate processors. Herein, the processor may execute software to control at least one other component (e.g., a hardware or software component) of the battery diagnosis apparatus 150 connected to the processor and may process or compute various data.

According to an embodiment, the battery diagnosis apparatus 150 may transmit a battery diagnosis result to an external source (e.g., a cloud server or a user terminal). Herein, the cloud server may provide a service for providing a battery diagnosis result to each of a plurality of users. Moreover, the user terminal may include a terminal such as a personal computer (PC), a smartphone, etc.

Hereinbelow, various embodiments where the calculating unit 152 and the diagnosing unit 153 diagnose abnormality of the battery unit will be described with reference to FIGS. 2 to 5. FIGS. 2 to 5 may be described using components of FIG. 1 (e.g., the battery module 120, the obtaining unit 151, the calculating unit 152, the diagnosing unit 153).

FIG. 2 is a view for describing an example in which a battery diagnosis apparatus diagnoses abnormality of a battery cell.

Referring to FIG. 2, the calculating unit 152 may include a first calculating unit 210 and a second calculating unit 220.

According to an embodiment, the obtaining unit 151 may transmit OCV data OCV₁, OCV₂, and OCV₃ of the battery cells 121, 122, and 123 to the first calculating unit 210.

According to an embodiment, the first calculating unit 210 may calculate OCV change values dOCV₁, dOCV₂, and dOCV₃ of each of the plurality of battery cells 121, 122, and 123 included in the battery module 120, in designated time windows, based on the OCV data OCV₁, _{OCV2}, and OCV₃.

According to an embodiment, the designated time window may be set to a time window between a first point in time before execution of charging of the battery cell 121, 122, or 123 and a second point in time after execution of the charging. For example, the first calculating unit 210 may calculate a difference value dOCV₁ between an OCV value at the first point in time and an OCV value at the second point in time, based on the OCV data OCV₁ of the battery cell 121. However, this is merely an embodiment and the technical spirit of the present disclosure may be applied as long as the first point in time and the second point in time are different points in time. For example, the first point in time may be a point in time after charging, and the second point in time may be a point in time after discharging.

According to an embodiment, the first calculating unit 210 may transmit the calculated OCV change values dOCV₁, dOCV₂, and dOCV₃ to the second calculating unit 220.

According to an embodiment, the second calculating unit 220 may calculate an average-to-OCV deviation value dOCV_{D1}, dOCV_{D2}, or dOCV_{D3} indicating a difference value between an average OCV change value of the battery cells 121, 122, and 123 and the OCV change value dOCV₁, dOCV₂, or dOCV₃ of a specific battery cell 121, 122, or 123 among the battery cells 121, 122, and 123, based on the OCV change value dOCV₁, dOCV₂, or dOCV₃ calculated by the first calculating unit 210. According to an embodiment, the second calculating unit 220 may calculate the average-to-OCV deviation value dOCV_{D1}, dOCV_{D2}, or dOCV_{D3} of each of the battery cells 121, 122, and 123 in the foregoing manner.

According to an embodiment, the second calculating unit 220 may transmit the calculated average-to-OCV deviation value dOCV_{D1}, dOCV_{D2}, or dOCV_{D3} to the diagnosing unit 153.

According to an embodiment, the diagnosing unit 153 may diagnose abnormality of the battery cell 121, 122, and/or 123 based on the average-to-OCV deviation value dOCV_{D1}, dOCV_{D}2, and/or dOCV_{D3} calculated by the second calculating unit 220. For example, the diagnosing unit 153 may diagnose abnormality of the battery cell 121 based on the average-to-OCV deviation value dOCV_{D1}.

According to an embodiment, the diagnosing unit 153 may diagnose abnormality of the battery cell 121 by using a scheme to compare the average-to-OCV deviation value dOCV_{D1}, dOCV_{D2}, and/or dOCV_{D3} with a threshold value or a diagnosis counting scheme.

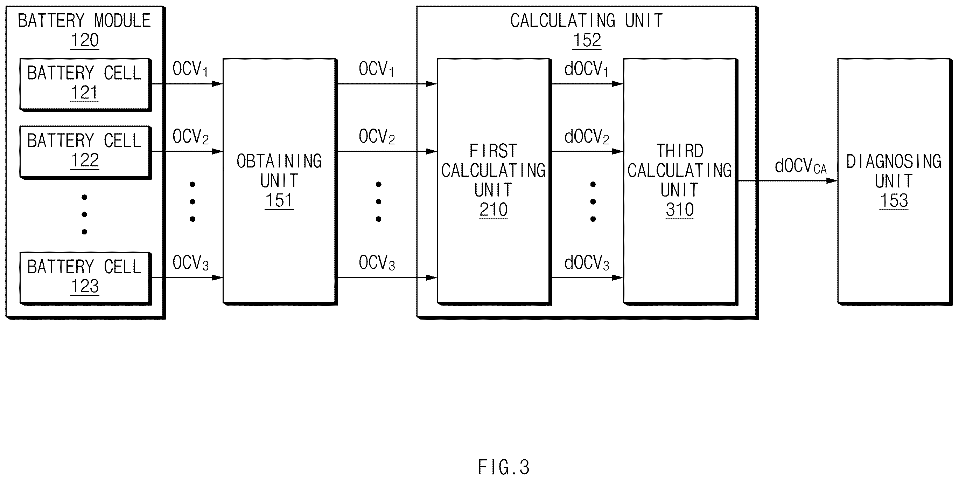

FIG. 3 is a view for describing an example in which a battery diagnosis apparatus diagnoses abnormality of a battery module.

Referring to FIG. 3, the calculating unit 152 may include a first calculating unit 210 and a third calculating unit 310. Hereinbelow, a detailed description of the components described with reference to FIG. 2 (e.g., the obtaining unit 151 and the first calculating unit 210) may be omitted.

According to an embodiment, the first calculating unit 210 may transmit the calculated OCV change values dOCV₁, dOCV₂, and dOCV₃ to the third calculating unit 310.

According to an embodiment, the third calculating unit 310 may calculate a maximum-average OCV deviation value dOCV_{CA} indicating a difference value between a maximum OCV change value of the battery cells 121, 122, and 123 and the average OCV change value of the battery cells 121, 122, and 123, based on the OCV change value dOCV₁, dOCV₂, or dOCV₃ calculated by the first calculating unit 210.

According to an embodiment, the third calculating unit 310 may transmit the calculated maximum-average OCV deviation value to the diagnosing unit 153.

According to an embodiment, the diagnosing unit 153 may diagnose abnormality of the battery module 120 based on the maximum-average OCV deviation value calculated by the third calculating unit 310.

According to an embodiment, the diagnosing unit 153 may diagnose abnormality of the battery module 120 by using a scheme to compare the maximum-average OCV deviation value with a threshold value or a diagnosis counting scheme.

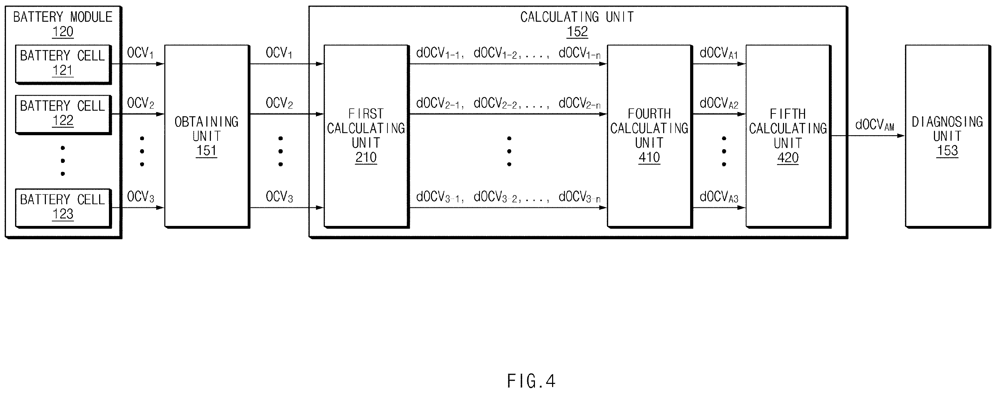

FIG. 4 is a view for describing an example in which a battery diagnosis apparatus diagnoses abnormality of a battery module.

Referring to FIG. 4, the calculating unit 152 may include the first calculating unit 210, a fourth calculating unit 410, and a fifth calculating unit 420.

According to an embodiment, the first calculating unit 210 may calculate a plurality of OCV change values dOCV₁₋₁, dOCV₁₋₂, ..., dOCV₁₋ₙ, dOCV₂₋₁, dOCV₂₋₂, ..., dOCV₂₋ₙ, dOCV₃₋₁, dOCV₃₋₂, ..., dOCV₃₋ₙ of each of the battery cells 121, 122, and 123, in a plurality of time windows, based on the OCV data OCV₁, OCV₂, and OCV₃. Herein, the plurality of time windows may be set to different time windows before and after charging.

For example, the first calculating unit 210 may calculate a plurality of OCV change values dOCV₁₋₁, dOCV₁₋₂, ..., dOCV₁₋ₙ in a plurality of time windows, based on the OCV data OCV₁ of the battery cell 121. Herein, each of the plurality of OCV change values dOCV₁₋₁, dOCV₁₋₂, ..., dOCV₁₋ₙ may one-to-one correspond to each of the plurality of time windows.

According to an embodiment, the first calculating unit 210 may transmit the plurality of calculated OCV change values dOCV₁₋₁, dOCV₁₋₂, ..., dOCV₁₋ₙ, dOCV₂₋₁, dOCV₂₋₂, ..., dOCV₂₋ₙ, dOCV₃₋₁, dOCV₃₋₂, ..., dOCV₃₋ₙ to the fourth calculating unit 410.

According to an embodiment, the fourth calculating unit 410 may calculate a plurality of reference values dOCV_{A1}, dOCV_{A2}, and dOCV_{A3} indicating average values of at least some of the plurality of calculated OCV change values dOCV₁₋₁, dOCV₁₋₂, ..., dOCV₁₋ₙ, dOCV₂₋₁, dOCV₂₋₂, ..., dOCV₂₋ₙ, dOCV₃₋₁, dOCV₃₋₂, ..., dOCV₃₋ₙ of each of the battery cells 121, 122, and 123, in a plurality of time windows. For example, the fourth calculating unit 410 may calculate the average value dOCV_{A1} of the 20 greatest OCV change values among the plurality of OCV change values dOCV₁₋₁, dOCV₁₋₂, ..., dOCV₁₋ₙ of the battery cell 121.

According to an embodiment, the fourth calculating unit 410 may transmit the plurality of calculated reference values dOCV_{A1}, dOCV_{A2}, and dOCV_{A3} to the fifth calculating unit 420.

According to an embodiment, the fifth calculating unit 420 may calculate a maximum reference value dOCV_{AM} indicating a maximum value among the plurality of reference values dOCV_{A1}, dOCV_{A2}, and dOCV_{A3} and transmit the same to the diagnosing unit 153.

According to an embodiment, the diagnosing unit 153 may diagnose abnormality of the battery module 120 based on the maximum reference value calculated by the fifth calculating unit 420.

According to an embodiment, the diagnosing unit 153 may diagnose abnormality of the battery module 120 by using a scheme to compare the maximum reference value with a threshold value or a diagnosis counting scheme.

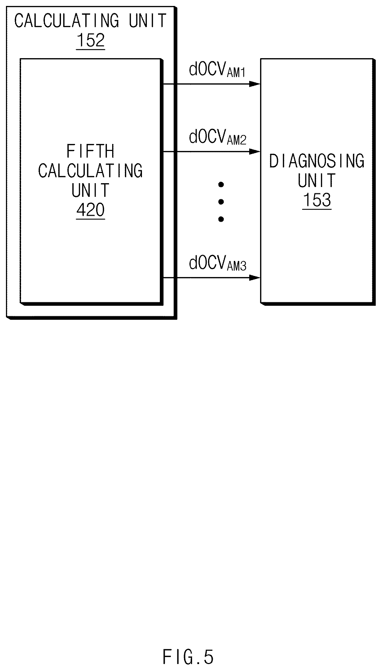

FIG. 5 is a view for describing an example in which a battery diagnosis apparatus diagnoses abnormality of a battery pack.

According to an embodiment, the fifth calculating unit 420 may calculate the plurality of maximum reference values dOCV_{AM1}, dOCV_{AM2}, and dOCV_{AM3} one-to-one corresponding respectively to the plurality of battery modules (e.g., the battery modules 120, 130, and 140 of FIG. 1) included in the battery pack (e.g., the battery pack 110 of FIG. 1). The fifth calculating unit 420 may calculate the maximum reference value dOCV_{AM1} of the battery module 120 as described with reference to FIG. 4. In the same manner, the fifth calculating unit 420 may calculate the maximum reference values dOCV_{AM2} and dOCV_{AM3} of the other battery modules 130 and 140 included in the battery pack 110.

According to an embodiment, the fifth calculating unit 420 may transmit the plurality of calculated reference values dOCV_{AM1}, dOCV_{AM2}, and dOCV_{AM3} to the diagnosing unit 153.

According to an embodiment, the diagnosing unit 153 may diagnose abnormality of the battery pack 110 based on the maximum reference value among the plurality of maximum reference values dOCV_{AM1}, dOCV_{AM2}, and dOCV_{AM3} calculated by the fifth calculating unit 420.

According to an embodiment, the diagnosing unit 153 may diagnose abnormality of the battery pack 110 by using a scheme to compare the plurality of maximum reference values dOCV_{AM1}, dOCV_{AM2}, and dOCV_{AM3} with a threshold value or a diagnosis counting scheme.

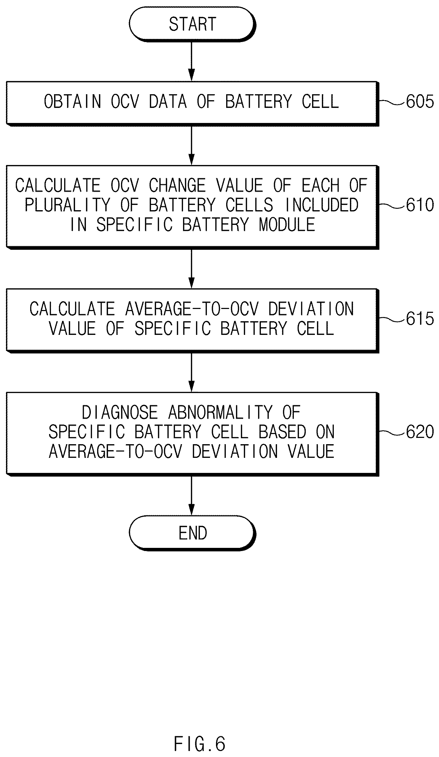

FIG. 6 is an operating flowchart of a battery diagnosis apparatus according to an embodiment. A description will be made of an operation of the battery diagnosis apparatus 150 of FIG. 1 with reference to FIG. 6 that may be described using the components of FIG. 1.

The embodiment shown in FIG. 6 may be an example, and an order of operations according to various embodiments of the present disclosure may be different from that shown in FIG. 6, and some operations shown in FIG. 6 may be omitted, the order of the operations may be changed, or the operations may be merged.

Referring to FIG. 6, in operation 605, the battery diagnosis apparatus 150 may obtain OCV data of the battery cells 121, 122, 123, 131, 132, 133, 141, 142, and/or 143. For example, the battery diagnosis apparatus 150 may measure voltages, currents, and/or temperatures of the battery cells 121, 122, 123, 131, 132, 133, 141, 142, and/or 143 and configure OCV data based on the measured information. In another example, the battery diagnosis apparatus 150 may receive OCV data of the battery cells 121, 122, 123, 131, 132, 133, 141, 142, and/or 143, obtained by the battery unit.

In operation 610, the battery diagnosis apparatus 150 may calculate an OCV change value indicating an OCV change value of each of a plurality of battery cells (e.g., the battery cells 121, 122, and 123) included in a specific battery module (e.g., the battery module 120), in a designated time window, based on the OCV data obtained in operation 605.

According to an embodiment, the designated time window may be set to a time window between a first point in time before execution of charging of the battery cell and a second point in time after execution of the charging.

According to an embodiment, the battery diagnosis apparatus 150 may extract OCV data in a designated voltage range from the OCV data. The battery diagnosis apparatus 150 may calculate the OCV change value of each of the plurality of battery cells, based on the extracted OCV data in the designated voltage range.

In operation 615, the battery diagnosis apparatus 150 may calculate an average-to-OCV deviation value indicating a difference value between an average OCV change value of the plurality of battery cells (e.g., the battery cells 121, 122, and 123) and an OCV change value of a specific battery cell (e.g., the battery cell 121, 122, or 123) among the plurality of battery cells, based on the OCV change value calculated in operation 610.

In operation 620, the battery diagnosis apparatus 150 may diagnose abnormality of a specific battery cell based on the average-to-OCV deviation value calculated in operation 615.

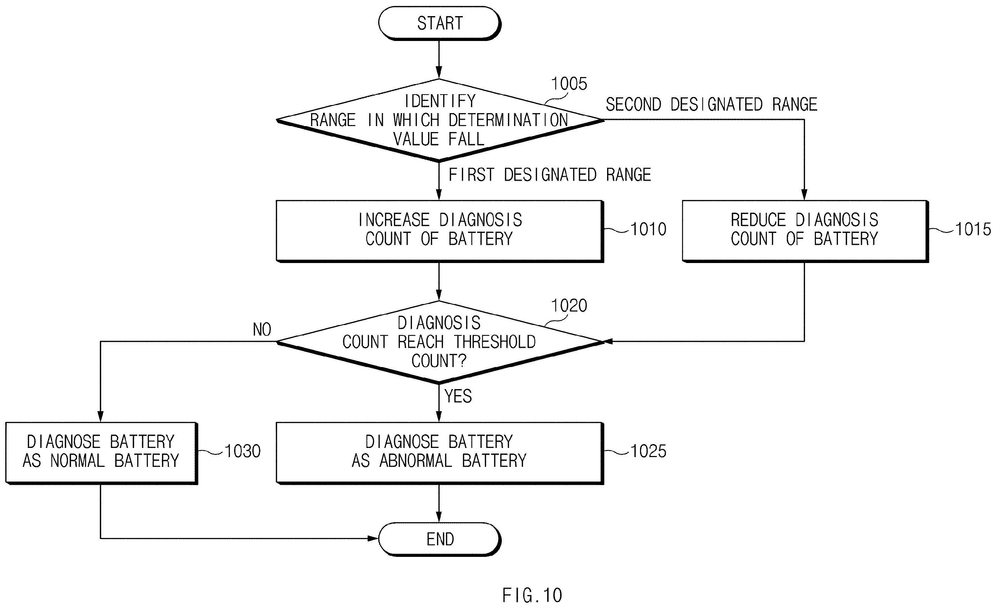

According to an embodiment, the battery diagnosis apparatus 150 may diagnose abnormality of the battery cell by using a scheme to compare the average-to-OCV deviation value with a threshold value or a diagnosis counting scheme. The diagnosis counting scheme may be described in detail with reference to FIG. 10.

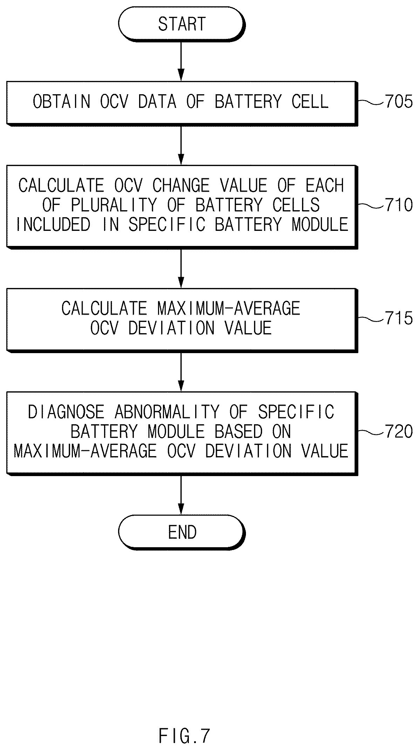

FIG. 7 is an operating flowchart of a battery diagnosis apparatus according to an embodiment. A description will be made of an operation of the battery diagnosis apparatus 150 of FIG. 1 with reference to FIG. 7 that may be described using the components of FIG. 1.

The embodiment shown in FIG. 7 may be an example, and an order of operations according to various embodiments of the present disclosure may be different from that shown in FIG. 7, and some operations shown in FIG. 7 may be omitted, the order of the operations may be changed, or the operations may be merged.

Referring to FIG. 7, in operation 705, the battery diagnosis apparatus 150 may obtain OCV data of the battery cells 121, 122, 123, 131, 132, 133, 141, 142, and/or 143. For example, the battery diagnosis apparatus 150 may measure voltages, currents, and/or temperatures of the battery cells 121, 122, 123, 131, 132, 133, 141, 142, and/or 143 and configure OCV data based on the measured information. In another example, the battery diagnosis apparatus 150 may receive OCV data of the battery cells 121, 122, 123, 131, 132, 133, 141, 142, and/or 143, obtained by the battery unit.

In operation 710, the battery diagnosis apparatus 150 may calculate an OCV change value indicating an OCV change value of each of a plurality of battery cells (e.g., the battery cells 121, 122, and 123) included in a specific battery module (e.g., the battery module 120), in a designated time window, based on the OCV data obtained in operation 705.

According to an embodiment, the designated time window may be set to a time window between a first point in time before execution of charging of the battery cell and a second point in time after execution of the charging.

According to an embodiment, the battery diagnosis apparatus 150 may extract OCV data in a designated voltage range from the OCV data. The battery diagnosis apparatus 150 may calculate the OCV change value of each of the plurality of battery cells, based on the extracted OCV data in the designated voltage range.

In operation 715, the battery diagnosis apparatus 150 may calculate a maximum-average OCV deviation value indicating a difference value between a maximum OCV change value of the battery cells and an average OCV change value of the battery cells, based on the OCV change value calculated in operation 710.

In operation 720, the battery diagnosis apparatus 150 may diagnose abnormality of a battery module based on the maximum-average OCV deviation value calculated in operation 715.

According to an embodiment, the battery diagnosis apparatus 150 may diagnose abnormality of the battery module by using a scheme to compare the maximum-average OCV deviation value with a threshold value or a diagnosis counting scheme. The diagnosis counting scheme may be described in detail with reference to FIG. 10.

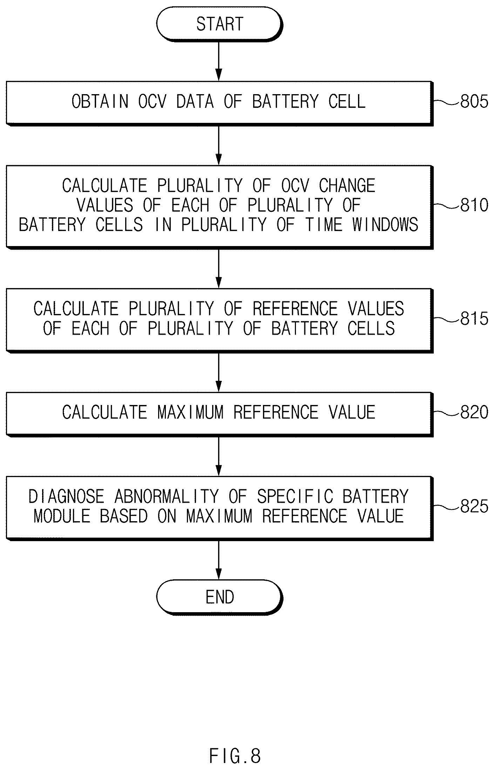

FIG. 8 is an operating flowchart of a battery diagnosis apparatus according to an embodiment. A description will be made of an operation of the battery diagnosis apparatus 150 of FIG. 1 with reference to FIG. 8 that may be described using FIG. 8.

The embodiment shown in FIG. 8 may be an example, and an order of operations according to various embodiments of the present disclosure may be different from that shown in FIG. 8, and some operations shown in FIG. 8 may be omitted, the order of the operations may be changed, or the operations may be merged.

Referring to FIG. 8, in operation 805, the battery diagnosis apparatus 150 may obtain OCV data of the battery cells 121, 122, 123, 131, 132, 133, 141, 142, and/or 143. For example, the battery diagnosis apparatus 150 may measure voltages, currents, and/or temperatures of the battery cells 121, 122, 123, 131, 132, 133, 141, 142, and/or 143 and configure OCV data based on the measured information. In another example, the battery diagnosis apparatus 150 may receive OCV data of the battery cells 121, 122, 123, 131, 132, 133, 141, 142, and/or 143, obtained by the battery unit.

In operation 810, the battery diagnosis apparatus 150 may calculate a plurality of OCV change values of each of a plurality of battery cells (e.g., the battery cells 121, 122, and 123), in a plurality of time windows, based on the OCV data obtained in operation 805. Herein, the plurality of time windows may be set to different time windows before and after charging.

According to an embodiment, the battery diagnosis apparatus 150 may extract OCV data in a designated voltage range from the OCV data. The battery diagnosis apparatus 150 may calculate the plurality of OCV change values of each of the plurality of battery cells, based on the extracted OCV data in the designated voltage range.

In operation 815, the battery diagnosis apparatus 150 may calculate the plurality of reference values of each of the plurality of battery cells. Herein, the reference value may indicate an average value of at least some of the plurality of OCV change values of a specific battery cell in the plurality of time windows. For example, the battery diagnosis apparatus 150 may calculate, as a reference value, an average value of the 20 greatest OCV change values among the plurality of OCV change values of the specific battery cell.

In operation 820, the battery diagnosis apparatus 150 may calculate a maximum reference value indicating a maximum value among the plurality of reference values calculated in operation 815.

In operation 825, the battery diagnosis apparatus 150 may diagnose abnormality of a specific battery module based on the maximum reference value calculated in operation 820.

According to an embodiment, the battery diagnosis apparatus 150 may diagnose abnormality of the specific battery module by using a scheme to compare the maximum reference value with a threshold value or a diagnosis counting scheme. The diagnosis counting scheme may be described in detail with reference to FIG. 10.

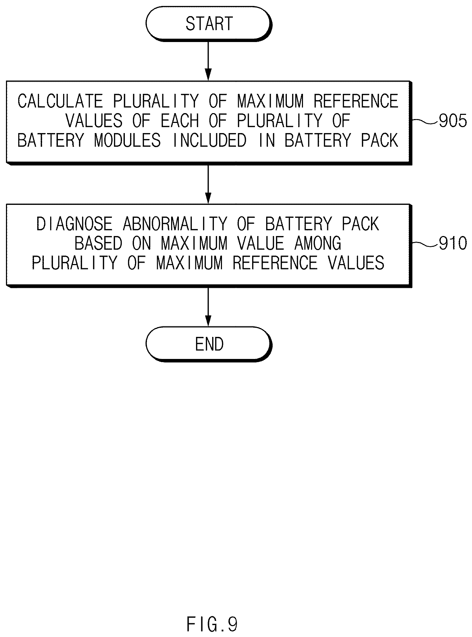

FIG. 9 is an operating flowchart of a battery diagnosis apparatus according to an embodiment. A description will be made of an operation of the battery diagnosis apparatus 150 of FIG. 1 with reference to FIG. 9 that may be described using FIG. 9.

The embodiment shown in FIG. 9 may be an example, and an order of operations according to various embodiments of the present disclosure may be different from that shown in FIG. 9, and some operations shown in FIG. 9 may be omitted, the order of the operations may be changed, or the operations may be merged.

Referring to FIG. 9, in operation 905, the battery diagnosis apparatus 150 may calculate the plurality of maximum reference values one-to-one corresponding respectively to the plurality of battery modules (e.g., the battery modules 120, 130, and 140 of FIG. 1) included in the battery pack (e.g., the battery pack 110 of FIG. 1). The battery diagnosis apparatus 150 may calculate the plurality of maximum reference values of the plurality of battery modules included in the battery pack in the same manner as described with reference to FIG. 8.

In operation 910, the battery diagnosis apparatus 150 may diagnose abnormality of the battery pack based on the maximum value among the plurality of maximum reference values calculated in operation 905.

According to an embodiment, the battery diagnosis apparatus 150 may diagnose abnormality of the battery pack by using a scheme to compare the maximum value among the plurality of maximum reference values with a threshold value or a diagnosis counting scheme. The diagnosis counting scheme may be described in detail with reference to FIG. 10.

FIG. 10 is an operating flowchart of a battery diagnosis apparatus according to an embodiment. A description will be made of an operation of the battery diagnosis apparatus 150 of FIG. 1 with reference to FIG. 10 that may be described using FIG. 10.

The embodiment shown in FIG. 10 may be an example, and an order of operations according to various embodiments of the present disclosure may be different from that shown in FIG. 10, and some operations shown in FIG. 10 may be omitted, the order of the operations may be changed, or the operations may be merged.

Referring to FIG. 10, in operation 1005, the battery diagnosis apparatus 150 may identify a range in which the determination value falls. Herein, the determination value may be the OCV change value, the average-to-OCV deviation value, the maximum-average OCV deviation value, the reference value, or the maximum reference value described with reference to FIGS. 6 to 9.

When the determination value is identified as falling in a first designated range in operation 1005, the battery diagnosis apparatus 150 may increase a diagnosis count of the battery in operation 1010. For example, the battery diagnosis apparatus 150 may increase the diagnosis count of the battery module 120 when the maximum-average OCV deviation value of the battery module 120, which is the determination value, is in the first designated range of 0.015 mV or greater.

When the determination value is identified as falling in a second designated range that is different from the first designated range in operation 1005, the battery diagnosis apparatus 150 may reduce the diagnosis count of the battery in operation 1015. For example, the battery diagnosis apparatus 150 may increase the diagnosis count of the battery module 120 when the maximum-average OCV deviation value of the battery module 120, which is the determination value, is in the second designated range below 0.015 mV.

In operation 1020, the battery diagnosis apparatus 150 may identify whether the diagnosis count of the battery reaches the threshold count.

When the diagnosis count of the battery is identified as reaching the threshold count ('YES') in operation 1020, the battery diagnosis apparatus 150 may diagnose the battery as an abnormal battery in operation 1025.

When the diagnosis count of the battery is identified as failing to reach the threshold count ('NO') in operation 1020, the battery diagnosis apparatus 150 may diagnose the battery as a normal battery in operation 1030.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery diagnosis apparatus comprising:
an obtaining unit configured to obtain open circuit voltage (OCV) data of a battery cell;
a calculating unit configured to calculate an OCV change value of each of a plurality of battery cells included in a specific battery module, in a designated time window, based on the OCV data, and calculate an average-to-OCV deviation value indicating a difference value between an average OCV change value of the plurality of battery cells and an OCV change value of a specific battery cell among the plurality of battery cells; and
a diagnosing unit configured to diagnose abnormality of the specific battery cell, based on the average-to-OCV deviation value of the specific battery cell.

2. The battery diagnosis apparatus of claim 1, wherein the designated time window is set to a time window between a first point in time before execution of charging and a second point in time after execution of the charging of the battery cell.

3. The battery diagnosis apparatus of claim 1, wherein the diagnosing unit is further configured to:
increase a diagnosis count of the specific battery cell when the average-to-OCV deviation value of the specific battery cell satisfies a first designated range;
reduce the diagnosis count of the specific battery cell when the average-to-OCV deviation value of the specific battery cell satisfies a second designated range that is different from the first designated range; and
diagnose the specific battery cell as an abnormal battery cell when the diagnosis count of the specific battery cell reaches a threshold count.

4. The battery diagnosis apparatus of claim 1, wherein the calculating unit is further configured to calculate a maximum-average OCV deviation value indicating a difference value between a maximum OCV change value of the plurality of battery cells and the average OCV change value of the plurality of battery cells, and
the diagnosing unit is further configured to diagnose abnormality of the specific battery module, based on the maximum-average OCV deviation value.

5. The battery diagnosis apparatus of claim 1, wherein the calculating unit is further configured to:
calculate a plurality of OCV change values of each of the plurality of battery cells, in a plurality of time windows, based on the OCV data;
calculate a plurality of reference values one-to-one corresponding respectively to each of the plurality of battery cells and indicating an average value of at least some of the plurality of OCV change values of each of the plurality of battery cells in the plurality of time windows; and
calculate a maximum reference value indicating a maximum value among the plurality of reference values, and
the diagnosing unit is further configured to diagnose abnormality of the specific battery module, based on the maximum reference value of the specific battery module.

6. The battery diagnosis apparatus of claim 5, wherein the calculating unit is further configured to calculate a plurality of maximum reference values one-to-one corresponding respectively to each of a plurality of battery modules included in a battery pack, and
the diagnosing unit is further configured to diagnose abnormality of the battery pack, based on a maximum value among the plurality of maximum reference values of the plurality of battery modules.

7. The battery diagnosis apparatus of claim 1, wherein the calculating unit is further configured to:
extract OCV data in a designated voltage range from the OCV data; and
calculate the OCV change value of each of the plurality of battery cells, based on the extracted OCV data in the designated voltage range.

8. A battery diagnosis method comprising:
obtaining open circuit voltage (OCV) data of a battery cell;
calculating an OCV change value of each of a plurality of battery cells included in a specific battery module, in a designated time window, based on the OCV data;
calculating an average-to-OCV deviation value indicating a difference value between an average OCV change value of the plurality of battery cells and an OCV change value of a specific battery cell among the plurality of battery cells; and
diagnosing abnormality of the specific battery cell, based on the average-to-OCV deviation value of the specific battery cell.

9. The battery diagnosis method of claim 8, wherein the designated time window is set to a time window between a first point in time before execution of charging of and a second point in time after execution of the charging of the battery cell.

10. The battery diagnosis method of claim 8, wherein the diagnosing of the abnormality of the specific battery cell comprises:
increasing a diagnosis count of the specific battery cell when the average-to-OCV deviation value of the specific battery cell satisfies a first designated range;
reducing the diagnosis count of the specific battery cell when the average-to-OCV deviation value of the specific battery cell satisfies a second designated range that is different from the first designated range; and
diagnosing the specific battery cell as an abnormal battery cell when the diagnosis count of the specific battery cell reaches a threshold count.

11. The battery diagnosis method of claim 8, further comprising:
calculating a maximum-average OCV deviation value indicating a difference value between a maximum OCV change value of the plurality of battery cells and the average OCV change value of the plurality of battery cells; and
diagnosing abnormality of the specific battery module, based on the maximum-average OCV deviation value.

12. The battery diagnosis method of claim 8, further comprising:
calculating a plurality of OCV change values of each of the plurality of battery cells, in a plurality of time windows, based on the OCV data;
calculating a plurality of reference values one-to-one corresponding respectively to each of the plurality of battery cells and indicating an average value of at least some of the plurality of OCV change values of each of the plurality of battery cells in the plurality of time windows;
calculating a maximum reference value indicating a maximum value among the plurality of reference values; and
diagnosing abnormality of the specific battery module, based on the maximum reference value of the specific battery module.

13. The battery diagnosis method of claim 12, further comprising:
calculating a plurality of maximum reference values one-to-one corresponding respectively to each of a plurality of battery modules included in a battery pack; and
diagnosing abnormality of the battery pack, based on a maximum value among the plurality of maximum reference values of the plurality of battery modules.

14. The battery diagnosis method of claim 8, wherein the calculating of the OCV change value of each of the plurality of battery cells comprises:
extracting OCV data in a designated voltage range from the OCV data; and
calculating the OCV change value of each of the plurality of battery cells, based on the extracted OCV data in the designated voltage range.
